# EUROPÄISCHE PATENTSCHRIFT

(11) **EP 2 601 820 B1**
(45) Veröffentlichungstag und Bekanntmachung des Hinweises auf die Patenterteilung: **07.11.2018**
(21) Anmeldenummer: 11728820.9
(22) Anmeldetag: 24.06.2011
(51) Int. Cl.: H05K 1/02, H05K 3/00, F21V 19/00, F21S 41/141

(54) **OPTOELEKTRONISCHES LEUCHTMODUL UND KFZ-SCHEINWERFER**
OPTOELECTRONIC LIGHTING MODULE AND MOTOR VEHICLE HEADLIGHT
MODULE LUMINEUX OPTOÉLECTRONIQUE ET PROJECTEUR DE VÉHICULE AUTOMOBILE

(30) Priorität: 02.08.2010 DE 102010033092
(43) Veröffentlichungstag der Anmeldung: 12.06.2013
(73) Patentinhaber: OSRAM Opto Semiconductors GmbH, 93055 Regensburg (DE)
(72) Erfinder: SINGER, Frank, 93128 Regenstauf (DE); HAUG, Thomas, 85051 Ingolstadt (DE); SAUERER, Alexander, 80333 Mü'nchen (DE); LUCKNER, Hagen, 93080 Pentling (DE); GRÖTSCH, Stefan, 93077 Lengfeld - Bad Abbach (DE)
(74) Vertreter: Epping - Hermann - Fischer
(86) Internationale Anmeldenummer: PCT/EP2011/060647
(87) Internationale Veröffentlichungsnummer: WO 2012/016760

(56) Entgegenhaltungen:
- WO-A1-2008/084878
- WO-A2-2009/034349
- JP-A- 2010 123 549
- US-A1- 2005 207 165
- US-A1- 2007 007 558
- US-A1- 2008 303 050
- US-A1- 2008 315 214
- US-A1- 2010 181 891
- US-B1- 6 448 642

## Beschreibung

Es wird ein optoelektronisches Leuchtmodul angegeben. Darüber hinaus wird ein Kfz-Scheinwerfer mit einem solchen Leuchtmodul angegeben.

In der Druckschrift US 2008/0008427 A1 ist ein lichtemittierendes Modul und ein Beleuchtungsbauteil für ein Fahrzeug angegeben.

Die Druckschrift US 2008/0303050 A1 betrifft ein Licht emittierendes Modul.

Eine Anordnung mit einer lötfreien Verbindung zwischen einer Leuchtdiode und einer Wärmesenke findet sich in der Druckschrift US 2008/0315214 A1.

Es ist in der Druckschrift US 2005/0207165 A1 ein LED-Modul mit einem Karteneinschub mit LEDs beschrieben.

In der Druckschrift US 2007/0007558 A1 findet sich ein Licht emittierendes Modul und eine Herstellungsmethode hierfür.

In der Druckschrift US 6,448,642 B1 ist eine mittels Druck an eine Wärmequelle befestigte Wärmesenke offenbart.

Eine Lichtquelle ist in der Druckschrift WO 2008/084878 A1 wiedergegeben.

Die Beschreibung einer Anordnung mit einer Leuchtdiode lässt sich der Druckschrift US 2010/0181891 A1 entnehmen.

Eine elektrisch von einem Grundkörper isolierte Vertikal-LED ist in der Druckschrift WO 2009/034349 A2 aufzufinden. Die LED ist hierbei auf einem Träger aufgebracht. Eine Leiterplatte ist vom Träger parallel zur Trägeroberseite beabstandet, während die dadurch entstandende Lücke von einer elektrischen Brücke überspannt ist.

Eine zu lösende Aufgabe besteht darin, ein Leuchtmodul mit einer guten Entwärmung anzugeben.
Diese Aufgabe wird durch ein optoelektronisches Leuchtmodul mit den Merkmalen des Anspruchs 1 gelöst.
Gemäß zumindest einer Ausführungsform des optoelektronischen Leuchtmoduls umfasst dieses einen Kühlkörper mit einer Kühlkörperoberseite. Der Kühlkörper dient insbesondere dazu, im Betrieb des Leuchtmoduls entstehende Abwärme aus dem Leuchtmodul abzuführen. Beispielsweise basiert der Kühlkörper auf einem Metall wie Kupfer oder Aluminium oder einer Metalllegierung oder besteht hieraus. Bevorzugt beträgt eine mittlere Wärmeleitfähigkeit der Wärmesenke mindestens 200 W/(m K). Eine Wärmekapazität des Kühlkörpers beträgt insbesondere mindestens 100 J/K oder mindestens 200 J/K. Gemäß zumindest einer Ausführungsform des Leuchtmoduls beinhaltet dieses zumindest eine Leiterplatte. Bei der Leiterplatte handelt es sich zum Beispiel um eine Metallkernplatine oder um eine bedruckte Leiterplatte. Die Leiterplatte ist bevorzugt an der Kühlkörperoberseite mechanisch fest angebracht, zum Beispiel angeklebt. Insbesondere erfolgt eine elektrische Kontaktierung des Leuchtmoduls über die Leiterplatte. Hierzu können an einer der Kühlkörperoberseite abgewandten Leiterplattenoberseite elektrische Kontaktbereiche angebracht sein.

Gemäß zumindest einer Ausführungsform des Leuchtmoduls weist dieses einen Träger mit einer Trägeroberseite und einer dieser gegenüberliegenden Trägerunterseite auf. Der Träger beinhaltet oder basiert zum Beispiel auf einer Keramik wie AlN oder einem Halbleitermaterial wie Si.

Gemäß zumindest einer Ausführungsform des Leuchtmoduls umfasst dieses einen oder mehrere optoelektronische Halbleiterchips. Bei den Halbleiterchips handelt es sich insbesondere um Leuchtdioden, die zum Beispiel eine auf einem III-V-Halbleitermaterial wie GaN basierende Halbleiterschichtenfolge umfassen. Die Halbleiterchips sind bevorzugt dazu eingerichtet, im Betrieb des Leuchtmoduls eine ultraviolette oder nahinfrarote Strahlung und/oder blaues Licht oder weißes Licht zu erzeugen. Die Halbleiterchips sind an der Trägeroberseite angebracht und mit dem Träger elektrisch verbunden. Hierzu können an der Trägeroberseite elektrische Leiterbahnen aufgebracht sein. Die Halbleiterchips sind beispielsweise elektrisch in Serie oder parallel geschaltet.

Gemäß zumindest einer Ausführungsform des Leuchtmoduls weist dieses zumindest eine Haltevorrichtung auf, die mindestens mittelbar an der Trägeroberseite aufliegt und die die Trägerunterseite an die Kühlkörperoberseite andrückt. Mit anderen Worten übt die Haltevorrichtung eine mechanische Kraft auf den Träger mit den Halbleiterchips auf, wodurch der Träger an den Kühlkörper angepresst ist. Insbesondere ist die Haltevorrichtung und/oder ein Teil der Haltevorrichtung, das in Kontakt mit dem Träger steht, elastisch verformbar. Die Haltevorrichtung ist zum Beispiel eine Feder oder umfasst eine solche.

Gemäß zumindest einer Ausführungsform des Leuchtmoduls ist der Träger elektrisch mit der Leiterplatte verbunden. Die elektrische Verbindung zwischen der Leiterplatte und dem Träger erfolgt bevorzugt nicht über den Kühlkörper. Eine elektrische Verbindung zwischen der Leiterplatte und dem Träger kann von dem Kühlkörper elektrisch isoliert sein.

Gemäß zumindest einer Ausführungsform des Leuchtmoduls ist die Haltevorrichtung von dem einen oder den mehreren Halbleiterchips elektrisch isoliert. Es besteht dann keine unmittelbare elektrische Verbindung zwischen der Haltevorrichtung und dem mindestens einen Halbleiterchip. Das heißt, die Haltevorrichtung ist von elektrischen Anschlusseinrichtungen für den Halbleiterchip verschieden. Insbesondere dient die Haltevorrichtung ausschließlich zu einer mechanischen und optional thermischen Kontaktierung des Trägers zu dem Kühlkörper.

In mindestens einer Ausführungsform des optoelektronischen Leuchtmoduls weist dieses einen Kühlkörper mit einer Kühlkörperoberseite sowie eine Leiterplatte und einen Träger mit einer Trägeroberseite und einer dieser gegenüberliegenden Trägerunterseite auf. An der Trägeroberseite ist einer oder sind mehrere optoelektronische Halbleiterchips angebracht. Die Halbleiterchips sind mit dem Träger elektrisch verbunden. Eine oder mehrere Haltevorrichtungen des Leuchtmoduls liegen mittelbar oder unmittelbar an der Trägeroberseite auf und drücken die Trägerunterseite an die Kühlkörperoberseite an. Der Träger ist elektrisch mit der Leiterplatte verbunden. Die Haltevorrichtung ist von dem mindestens einen Halbleiterchip elektrisch isoliert.

Dadurch, dass durch die Haltevorrichtung der Träger auf den Kühlkörper angedrückt ist, kann auf ein Verbindungsmittel zu einer mechanischen Befestigung des Trägers an dem Kühlkörper, wobei das Verbindungsmittel zwischen den Träger und dem Kühlkörper angebracht ist, verzichtet werden. Hierdurch ist ein thermischer Widerstand zwischen den Halbleiterchips und dem Kühlkörper reduzierbar.

Gemäß zumindest einer Ausführungsform des Leuchtmoduls ist der Träger, auf dem die Halbleiterchips angebracht sind, in lateraler Richtung von der Leiterplatte beabstandet. Es ist also eine Lücke zwischen dem Träger und der Leiterplatte gebildet, in Draufsicht auf die Kühlkörperoberseite gesehen. Bevorzugt erstreckt sich diese Lücke ringsum um die Leiterplatte, sodass sich der Träger und die Leiterplatte in lateraler Richtung nirgends berühren. Alternativ hierzu ist es ebenso möglich, dass sich der Träger und die Leiterplatte in lateraler Richtung stellenweise unmittelbar berühren. Beispielsweise ist es möglich, dass sich die Lücke nur an zwei oder drei Seiten entlang der Leiterplatte erstreckt und dass die Leiterplatte an ein oder an zwei Seiten an dem Träger anliegt.

Gemäß zumindest einer Ausführungsform des Leuchtmoduls sind der Träger und die Leiterplatte über eine elektrische Brücke miteinander elektrisch verbunden. Die Brücke verbindet elektrische Leiterbahnen an der Trägeroberseite mit korrespondierenden elektrischen Leiterbahnen an einer Leiterplattenoberseite. Es ist möglich, dass die Brücke die gegebenenfalls vorhandene Lücke zwischen dem Träger und der Leiterplatte überspannt. Zum Beispiel ist die Brücke durch einen Bonddraht, durch ein elektrisch leitfähiges Band oder durch eine Schicht oder eine Schichtenfolge elektrisch leitfähiger und optional elektrisch isolierender Schichten, die unmittelbar auf die Trägeroberseite sowie auf die Leiterplattenoberseite aufgebracht sind, gebildet.

Gemäß zumindest einer Ausführungsform des Leuchtmoduls weist die Leiterplatte eine Öffnung auf, die die Leiterplatte vollständig durchdringt. Die Öffnung ist bevorzugt an mindestens drei Seiten oder an mindestens vier Seiten von einem Material der Leiterplatte in lateraler Richtung umgeben. Mit anderen Worten kann die Leiterplatte in lateraler Richtung den Träger ringsum umgeben. In der Öffnung kann sich der Träger mit dem mindestens einen Halbleiterchip befinden, wobei der Träger in eine Richtung weg von dem Kühlkörper die Leiterplatte bevorzugt wenigstens stellenweise überragt.

Gemäß zumindest einer Ausführungsform des Leuchtmoduls steht die Haltevorrichtung, die den Träger an den Kühlkörper andrückt, nicht in Kontakt mit der Leiterplatte. Es berühren sich also die Leiterplatte und die Haltevorrichtung dann nicht. Hierdurch ist eine gute Wärmeübertragung von dem Träger oder den Halbleiterchips direkt auf den Kühlkörper, ohne Umweg über die Leiterplatte, gewährleistbar.

Gemäß zumindest einer Ausführungsform des Leuchtmoduls drückt die Haltevorrichtung den Träger im bestimmungsgemäßen Gebrauch mit einer mechanischen Kraft zwischen einschließlich 5 N und 100 N, insbesondere mit einer Kraft zwischen einschließlich 20 N und 60 N an die Kühlkörperoberseite an. Zusätzlich oder alternativ beträgt ein mittlerer Anpressdruck der Trägerunterseite an die Kühlkörperoberseite zwischen einschließlich 0,2 MPa und 20 MPa, insbesondere zwischen einschließlich 0,4 MPa und 2 MPa.

Gemäß zumindest einer Ausführungsform des Leuchtmoduls weist die Trägerunterseite und/oder die Kühlkörperoberseite eine mittlere Rauheit, auch als Rₐ bezeichnet, von höchstens 10 µm oder von höchstens 5 µm oder von höchstens 2 µm auf. Mit anderen Worten sind die Trägerunterseite und/oder die Kühlkörperoberseite glatt. Hierdurch ist ein guter thermischer Kontakt zwischen dem Träger und dem Kühlkörper gewährleistbar.

Gemäß zumindest einer Ausführungsform des Leuchtmoduls sind die Trägerunterseite und/oder die Kühlkörperoberseite planar und eben geformt, insbesondere diejenigen Bereiche der Kühlkörperoberseite, auf denen der Träger aufliegt. Mit anderen Worten ist keine gezielte zweidimensionale oder dreidimensionale Strukturierung der Trägerunterseite und der Bereiche der Kühlkörperoberseite, an denen der Träger aufliegt, vorgenommen. Es können der Träger und der Kühlkörper also flach aneinander anliegen.

Gemäß zumindest einer Ausführungsform des Leuchtmoduls steht die Trägerunterseite stellenweise oder vollständig in unmittelbarem Kontakt zu der Kühlkörperoberseite. Der Träger und der Kühlkörper können sich also berühren. Ohne Berücksichtigung einer mikroskopischen Rauheit der Trägerunterseite und der Kühlkörperoberseite, berührt die Trägerunterseite bevorzugt ganzflächig die Kühlkörperoberseite. Hierdurch ist ein besonders geringer thermischer Widerstand zwischen dem Träger und dem Kühlkörper erzielbar.

Gemäß zumindest einer Ausführungsform des Leuchtmoduls befindet sich zwischen der Trägerunterseite und der Kühlkörperoberseite stellenweise oder ganzflächig eine Zwischenschicht. Die Zwischenschicht ist zur Verbesserung der thermischen Ankopplung des Trägers an den Kühlkörper eingerichtet. Insbesondere ist die Zwischenschicht dazu geeignet, Lücken zwischen dem Träger und dem Kühlkörper, die durch eine mikroskopische Rauheit der Trägerunterseite und/oder der Kühlkörperoberseite bedingt sind, auszufüllen. Mit anderen Worten kann eine Kontaktfläche zwischen dem Träger und dem Kühlkörper mittels der Zwischenschicht vergrößert sein. Eine mittlere Dicke der Zwischenschicht beträgt bevorzugt höchstens 10 µm oder höchstens 2,5 µm oder höchstens 1 µm. Mit anderen Worten ist die Zwischenschicht vergleichsweise dünn ausgebildet und stellt daher keinen signifikanten thermischen Widerstand dar. Speziell ist durch die Zwischenschicht ein thermischer Widerstand zwischen dem Träger und dem Kühlkörper reduziert, im Vergleich zu einer äquivalenten Anordnung ohne der Zwischenschicht. Zum Beispiel umfasst die Zwischenschicht ein Silikon oder besteht hieraus.

Gemäß zumindest einer Ausführungsform des Leuchtmoduls weist der Kühlkörper an der Kühlkörperoberseite eine Wanne oder eine Nut auf. Der Träger mit den Halbleiterchips ist in der Wanne oder Nut angebracht, wobei der Träger die Wanne oder Nut in eine Richtung weg von einem Wannenboden bevorzugt überragt. Der Wannenboden ist insbesondere eben ausgestaltet. Es kann der Träger flach und eben an dem Wannenboden aufliegen. Durch die Wanne ist der Träger in einer lateralen Richtung relativ zu dem Kühlkörper führbar und/oder fixierbar.

Gemäß zumindest einer Ausführungsform des Leuchtmoduls ist die Haltevorrichtung als Feder oder als Band gestaltet oder weist zumindest eines dieser Elemente auf, beispielsweise in Verbindung mit einem Befestigungselement wie einer Schraube oder einer Niete oder einem Lötkontakt. Ein Material der Haltevorrichtung weist bevorzugt eine spezifische Wärmeleitfähigkeit von mindestens 80 W/(K m) auf. Beispielsweise weist die Haltevorrichtung Kupfer oder eine Kupferlegierung auf oder besteht hieraus.

Gemäß zumindest einer Ausführungsform des Leuchtmoduls steht die Haltevorrichtung stellenweise in unmittelbarem thermischen Kontakt mit dem Kühlkörper. Zum Beispiel ist die Haltevorrichtung dann stellenweise an eine Begrenzungsfläche des Kühlkörpers wie der Kühlkörperoberseite angedrückt oder aufgepresst. Weist die Haltevorrichtung mehrere Teile auf, so ist bevorzugt mindestens eines der Teile sowohl unmittelbar mit dem Träger als auch unmittelbar mit dem Kühlkörper thermisch kontaktiert. Beispielsweise berührt das entsprechende Teil der Haltevorrichtung die Trägeroberseite und/oder die Kühlkörperoberseite.

Gemäß zumindest einer Ausführungsform des Leuchtmoduls unterscheiden sich die mittleren thermischen Ausdehnungskoeffizienten der Leiterplatte und/oder des Kühlkörpers von einem thermischen Ausdehnungskoeffizienten des Trägers um höchstens einen Faktor 4 oder um höchstens einen Faktor 3. Hierdurch sind Materialspannungen aufgrund unterschiedlicher thermischer Ausdehnungen reduzierbar, wodurch eine Lebensdauer des Leuchtmoduls erhöht sein kann.

Gemäß zumindest einer Ausführungsform des Leuchtmoduls umfasst dieses mindestens einen Anschlag. Der Anschlag ist an mindestens einer Seitenfläche des Trägers angebracht. Bevorzugt steht der Anschlag in mittelbarem oder unmittelbarem Kontakt mit der Kühlkörperoberseite und dem Träger. Der Anschlag ist dazu eingerichtet, ein laterales Verschieben des Trägers relativ zu der Kühlkörperoberseite zu unterbinden oder zu reduzieren. Der Anschlag ist beispielsweise ein Fixpunkt für den Träger relativ zu dem Kühlkörper. Insbesondere befindet sich der Anschlag höchstens an einer oder an zwei Seitenflächen des Trägers, wobei sich die Seitenflächen, an denen sich der Anschlag befindet, bevorzugt nicht gegenüber liegen.

Gemäß zumindest einer Ausführungsform des Leuchtmoduls ist die Haltevorrichtung dauerhaft und im bestimmungsgemäßen Gebrauch des Leuchtmoduls nicht reversibel lösbar an dem Kühlkörper befestigt. Zum Beispiel ist die Haltevorrichtung an dem Kühlkörper verklebt oder verlötet.

Es wird darüber hinaus ein Kfz-Scheinwerfer angegeben. Der Kfz-Scheinwerfer beinhaltet mindestens ein optoelektronisches Leuchtmodul, wie in Verbindung mit einer oder mehrerer der oben genannten Ausführungsformen beschrieben. Merkmale des Kfz-Scheinwerfers sind daher auch für das hier beschriebene Leuchtmodul offenbart und umgekehrt.

Nachfolgend wird hier ein beschriebenes optoelektronisches Leuchtmodul sowie ein hier beschriebener Kfz-Scheinwerfer unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1 bis 6: schematische Darstellungen von Ausführungsbeispielen von hier beschriebenen optoelektronischen Leuchtmodulen, und
- Figur 7: eine schematische Darstellung einer Abwandlung eines Leuchtmoduls.

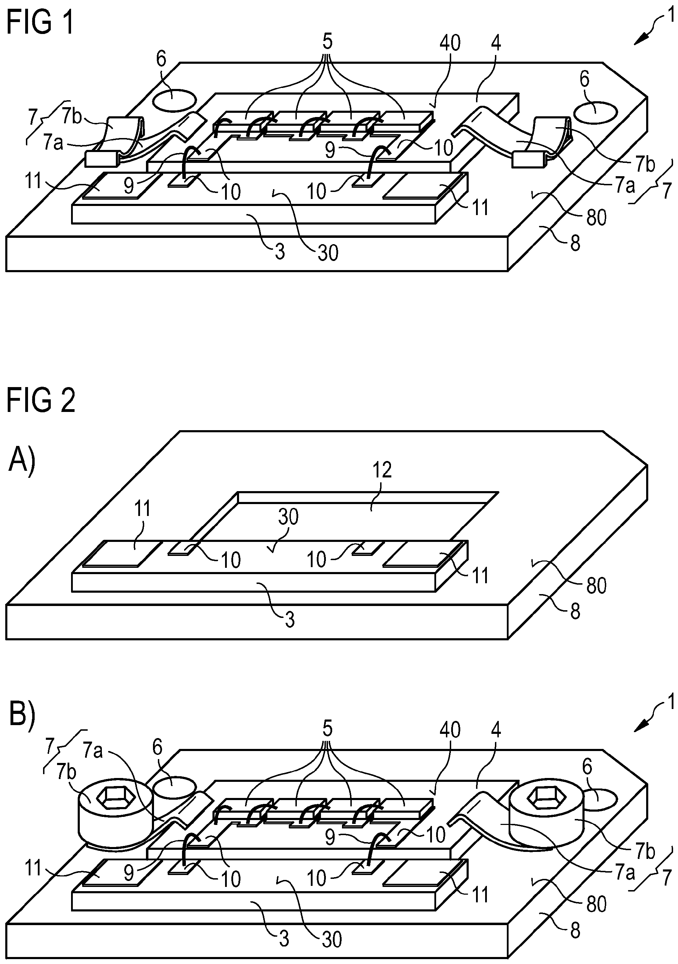

In Figur 1 ist eine perspektivische Darstellung eines Ausführungsbeispiels eines optoelektronischen Leuchtmoduls 1 gezeigt. Zum Beispiel ist das Leuchtmodul 1 in einem Kfz-Scheinwerfer verbaut. Das Leuchtmodul 1 umfasst einen Kühlkörper 8 mit einer Kühlkörperoberseite 80. An der Kühlkörperoberseite 80 befindet sich fest montiert eine Leiterplatte 3, beispielsweise eine Metallkernplatine. Weiterhin sind an der Kühlkörperoberseite 80 zwei Haltevorrichtungen 7 sowie ein Träger 4 mit mehreren optoelektronischen Halbleiterchips 5 angebracht.

Sowohl an einer dem Kühlkörper 8 abgewandten Trägeroberseite 40 als auch an einer dem Kühlkörper 8 abgewandten Leiterplattenoberseite 30 befinden sich elektrische Leiterbahnen 10, die teilweise insbesondere in der Leiterplatte 3 vergraben sein können. Eine elektrische Verbindung zwischen den Leiterbahnen 10 des Trägers 4 und der Leiterplatte 3 erfolgt über elektrische Brücken 9, die zum Beispiel durch Bonddrähte realisiert sind.

Weiterhin sind über die Leiterbahnen 10 an der Trägeroberseite 40 die Halbleiterchips 5 elektrisch in Reihe geschaltet. Anders als dargestellt ist es ebenso möglich, dass die Halbleiterchips 5 einzeln oder in Gruppen einzeln ansteuerbar sind. In diesem Fall verlaufen sowohl an der Leiterplatte 3 als auch an dem Träger 4 mehr Leiterbahnen 10 als in Figur 1 dargestellt. Ebenso sind in diesem Fall bevorzugt mehr als zwei Brücken 9 zur elektrischen Verbindung zwischen dem Träger 4 und der Leiterplatte 3 vorhanden. Zu einer externen elektrischen Kontaktierung sind an der Leiterplatte 3 in Eckbereichen Lötpads 11 vorgesehen.

Die Haltevorrichtungen 7 weisen jeweils zwei Teile 7a, 7b auf. Das Teil 7a ist als Federbügel gestaltet, der unmittelbar auf die Trägeroberseite 40 drückt und der unmittelbar in Kontakt zu der Kühlkörperoberseite 80 steht. Das Teil 7a ist durch das Teil 7b dauerhaft an die Kühlkörperoberseite 80 angedrückt und befestigt. Über die Haltevorrichtungen 7 ist der Träger 4 verbindungsmittelfrei auf die Kühlkörperoberseite 80 aufgedrückt. Der Träger 4 und der Kühlkörper 8 stehen in direktem, unmittelbaren Kontakt miteinander, ohne dass sich ein Verbindungsmittel zwischen der Kühlkörperoberseite 80 und einer Trägerunterseite befindet.

Optional weist der Kühlkörper 8 Befestigungseinrichtungen 6 auf, mit denen das gesamte Leuchtmodul 1 an eine externe Montageplatte befestigbar ist. Die Befestigungseinrichtungen 6 sind beispielsweise Bohrungen zur Aufnahme von Schrauben.

Eine Dicke des Trägers liegt beispielsweise zwischen einschließlich 200 µm und 1 mm, insbesondere zwischen einschließlich 300 µm und 700 µm. Laterale Abmessungen des Trägers 4 liegen zum Beispiel zwischen einschließlich 3 mm x 5 mm und 5 mm x 8 mm, falls das Leuchtmodul 1 mehrere Halbleiterchips 5 umfasst, oder zwischen einschließlich 1 mm x 4 mm und 3 mm x 5 mm, falls das Leuchtmodul nur einen einzigen Halbleiterchip 5 beinhaltet, anders als in Figur 1 dargestellt. Beispielsweise fällt im bestimmungsgemäßen Betrieb des Leuchtmoduls 1 pro Halbleiterchip 5 eine Abwärme von mindestens 3 W an.

Der Träger 4 beinhaltet zum Beispiel eine Keramik wie Aluminiumnitrid oder Aluminiumoxid oder besteht aus einer solchen Keramik. Ebenso ist es möglich, dass der Träger 4 Siliziumnitrid oder Siliziumcarbid umfasst oder hieraus besteht oder dass der Träger 4 aus einem Halbleitermaterial wie Silizium oder Germanium gefertigt ist. Weist der Träger 4 ein elektrisch leitfähiges Material auf, so ist dieses bevorzugt mindestens stellenweise mit einer dünnen Passivierungsschicht versehen, beispielsweise aus Siliziumnitrid, die nur einen vernachlässigbaren thermischen Widerstand aufweist.

Geeignete Materialien für den Träger 4 mit einer hohen thermischen Leitfähigkeit und einer thermischen Ausdehnung ähnlich der des Halbleiterchips wie Keramiken weisen typisch einen thermischen Ausdehnungskoeffizienten von circa 5 x 10⁻⁶ K⁻¹ auf. Metalle für den Kühlkörper wie Aluminium oder Kupfer weisen dahingegen einen vergleichsweise großen thermischen Ausdehnungskoeffizienten im Bereich von etwa 15 x 10⁶ K⁻¹ bis circa 25 x 10⁶ K⁻¹ auf. Ein Verbindungsmittel zwischen dem Träger 4 und dem Kühlkörper 8, alternativ zu den Ausgestaltungen gemäß den hier beschriebenen Ausführungsbeispielen, muss in der Lage sein, die Unterschiede im thermischen Ausdehnungskoeffizienten auszugleichen, da ansonsten sich nach vielmaligem Einschalten und Ausschalten des Leuchtmoduls der Träger von dem Kühlkörper lösen kann.

Starre metallische Lote oder zum Beispiel mit Silber versetzte Epoxide als Verbindungsmittel sind im Regelfall nicht in der Lage, die Spannungen aufgrund der unterschiedlichen thermischen Ausdehnungen zwischen dem Träger und dem Kühlkörper zu kompensieren. Hierzu sind vergleichsweise weiche, insbesondere auf einem Silikon basierende Kleber vonnöten, die zum Beispiel mit Bariumnitrid gefüllt sind. Solche Kleber weisen jedoch eine vergleichsweise geringe thermische Leitfähigkeit in der Größenordnung von 2 W/(m K) auf und sind zudem in relativ großen Schichtdicken zwischen 20 µm und 60 µm aufzutragen. Durch den hohen thermischen Widerstand der Verbindungsmittelschicht ist die Entwärmbarkeit des Leuchtmoduls somit signifikant reduziert. Dadurch, dass bei dem hier beschriebenen Leuchtmodul 1 über die Haltevorrichtungen 7a, 7b der Träger 4 unmittelbar und verbindungsmittelfrei auf dem Kühlkörper 8 angepresst ist, ist ein thermischer Widerstand zwischen dem Kühlkörper 8 und dem Träger 4 reduziert. Beispielsweise beträgt der thermische Widerstand höchstens 2,5 K/W oder höchstens 2,0 K/W.

Beim Ausführungsbeispiel gemäß Figur 2 weist der Kühlkörper 8 an der Kühlkörperoberseite 80 eine Wanne 12 zur Aufnahme des Trägers 4 auf, vergleiche Figur 2A. Durch diese Wanne ist der Träger 4, beispielsweise mit einer Toleranz von höchstens 500 µm oder von höchstens 250 µm, in einer laterale Richtung relativ zu dem Kühlkörper 8 fixiert.

Im Unterschied zum Ausführungsbeispiel gemäß Figur 1 ist die Haltevorrichtung 7 reversibel an dem Kühlkörper 8 befestigt. Die Teile 7b sind durch Schrauben gebildet, die die Teile 7a auf die Kühlkörperoberseite 80 sowie auf die Trägeroberseite 40 aufdrücken. Wie auch in allen anderen Ausführungsbeispielen dienen die Haltevorrichtungen 7 bevorzugt nur zu einer mechanischen und optional zu einer thermischen Anbindung des Trägers 4 an den Kühlkörper 8. Die Haltevorrichtungen 7 sind von den Leiterbahnen 10 sowie von den Halbleiterchips 5 elektrisch isoliert. Dadurch, dass die mechanische und die elektrische Anbindung des Trägers 4 voneinander separiert sind, sind insbesondere die Haltevorrichtungen 7 vergleichsweise frei designbar.

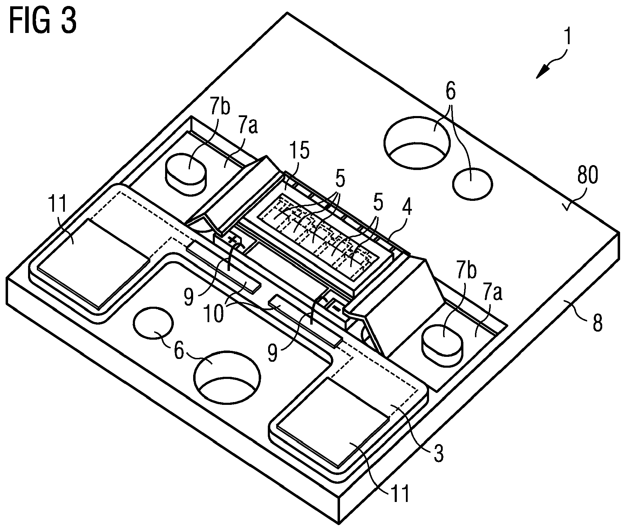

Bei dem weiteren Ausführungsbeispiel des Leuchtmoduls 1 gemäß Figur 3 sind die Teile 7b der Haltevorrichtungen ebenfalls durch reversibel bedienbare Schrauben gebildet. Die Teile 7a erstrecken sich über mindestens 80 % von kurzen Seiten des Trägers 4, in Draufsicht auf die Kühlkörperoberseite 80 gesehen. Die Leiterplatte 3 befindet sich nur über einer Hälfte der Kühlkörperoberseite 80. Anders als dargestellt ist es ebenso möglich, dass die Leiterplatte 3 den Träger 4 ringsum vollständig umschließt oder sich zumindest entlang zweier oder dreier Seiten des Trägers 4 erstreckt. Wie auch in allen anderen Ausführungsbeispielen sind die Halbleiterchips 5 optional von einer strahlungsdurchlässigen Abdeckung 15 überdeckt, wobei der Abdeckung 15 eine in den Figuren nicht dargestellte Optik nachgeordnet sein kann.

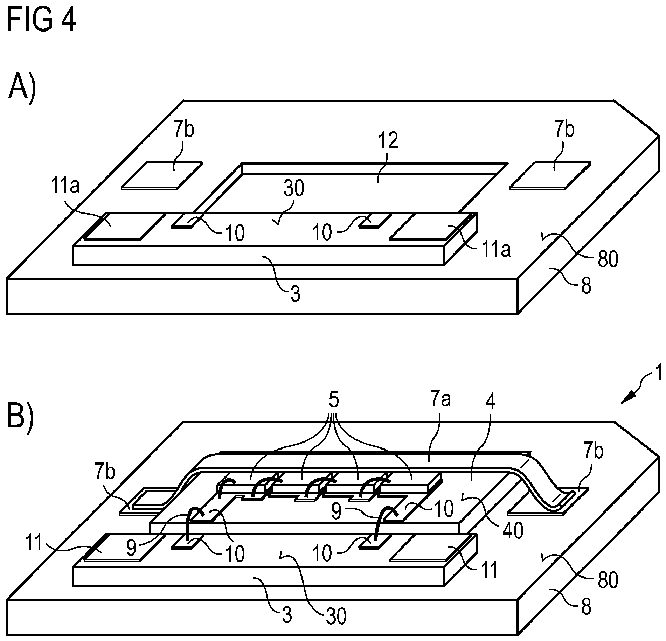

Beim Ausführungsbeispiel gemäß Figur 4 befindet sich der Träger 4 in der Wanne 12 und überragt diese. Die Teile 7b der Befestigungsvorrichtung sind durch Lötkontaktflächen gebildet. Der Träger 4 ist über das Teil 7a, das ein Band, beispielsweise aus Kupfer oder einer Kupferlegierung, ist, an dem Kühlkörper 8 angepresst. Das Teil 7a ist mit den Teilen 7b über eine Lötverbindung oder über eine Klebeverbindung befestigt. Zum Beispiel weist das Band eine Dicke zwischen einschließlich 100 µm und 300 µm auf. Weiterhin erstreckt sich das Teil 7a entlang des gesamten Trägers 4 und bedeckt zum Beispiel mindestens 15 % oder mindestes 20 % der Trägeroberseite 40.

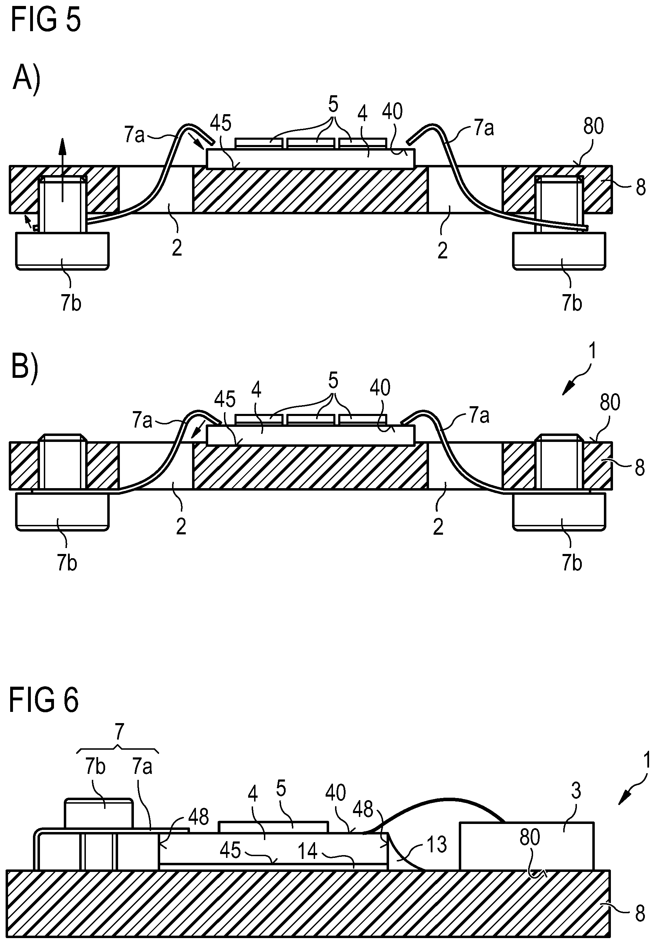

In Figur 5 ist ein weiteres Ausführungsbeispiel des Leuchtmoduls 1 dargestellt, in Figur 5A vor der Befestigung des Trägers 4 und in Figur 5B nachdem der Träger 4 an den Kühlkörper 8 angepresst ist. Die Teile 7a der Haltevorrichtung sind durch Bügel gebildet, die durch Öffnungen 2 hindurch von einer Rückseite des Kühlkörpers 8 zu der Trägeroberseite 40 reichen. Die Teile 7b sind durch Schrauben gebildet. Durch ein Anziehen der Schrauben der Teile 7b werden die bügelartigen Teile 7a an die Trägeroberseite 40 angedrückt, wodurch eine Befestigung des Trägers 4 mit den Halbleiterchips 5 erfolgt.

Beim Ausführungsbeispiel des Leuchtmoduls 1 gemäß Figur 6 befindet sich zwischen der Trägerunterseite 45 und der Kühlkörperoberseite 80 eine Zwischenschicht 14. Die Zwischenschicht 14 weist eine geringe Dicke von beispielsweise höchstens 1 µm auf. Im Vergleich zu einem unmittelbaren Anpressen des Trägers 4 an den Kühlkörper 8 ist durch die Zwischenschicht 14 ein thermischer Widerstand zwischen dem Träger 4 und dem Kühlkörper 8 reduziert, da durch die Zwischenschicht 14 eine Rauheit der Kühlkörperoberseite 80 sowie der Trägerunterseite 45 ausgleichbar sind.

Die Zwischenschicht 14 dient nicht zu einer mechanischen Fixierung des Trägers 4. Hierzu dienen die Haltevorrichtungen 7, von denen in Figur 6 exemplarisch nur eine einzige dargestellt ist. Das Teil 7a der Haltevorrichtung 7 ist als Bügel gestaltet, dessen eines Ende an der Trägeroberseite 40 aufliegt und dessen anderes Ende sich an der Kühlkörperoberseite abstützt, wobei letztgenanntes Ende im Wesentlichen senkrecht zu der Kühlkörperoberseite 80 orientiert ist. Ein Anpressen des Teils 7a auf die Trägeroberseite 40 erfolgt über das Teil 7b, das beispielsweise als Schraube ausgeformt ist.

Optional, wie auch in allen anderen Ausführungsbeispielen, ist es möglich, dass an Seitenflächen 48 des Trägers 4 punktartig oder in Form einer Linie ein Anschlag 13 angebracht ist. Über den Anschlag 13 ist insbesondere ein Verrutschen des Trägers 4 vor oder während des Anpressens durch die Haltevorrichtungen 7 vermeidbar oder reduzierbar. Beispielsweise ist der Anschlag 13 durch ein vergleichsweise weiches, thermische Ausdehnungen kompensierendes Silikon gebildet. Ebenso ist es möglich, dass der Anschlag 13 beispielsweise durch einen oder mehrere Lötpunkte gebildet ist.

Bevorzugt erstreckt sich der Anschlag 13 nur auf eine oder nur auf zwei Seitenflächen 48 des Trägers 4. Gemäß Figur 6 ist der Anschlag 13 nach dem Träger 4 auf den Kühlkörper 8 aufgebracht und der Anschlag 13 ist im Querschnitt näherungsweise dreieckig geformt und schließt sich unmittelbar an die Seitenfläche 48 sowie an die Kühlkörperoberseite 80 an. Alternativ hierzu ist es möglich, dass der Anschlag 13 durch eine Strukturierung der Kühlkörperoberseite 80 oder durch ein vor dem Träger 4 an dem Kühlkörper 8 befestigtes Materialstück, beispielsweise auch anders als in den Figuren dargestellt durch die Leiterplatte 3 selbst, gebildet ist.

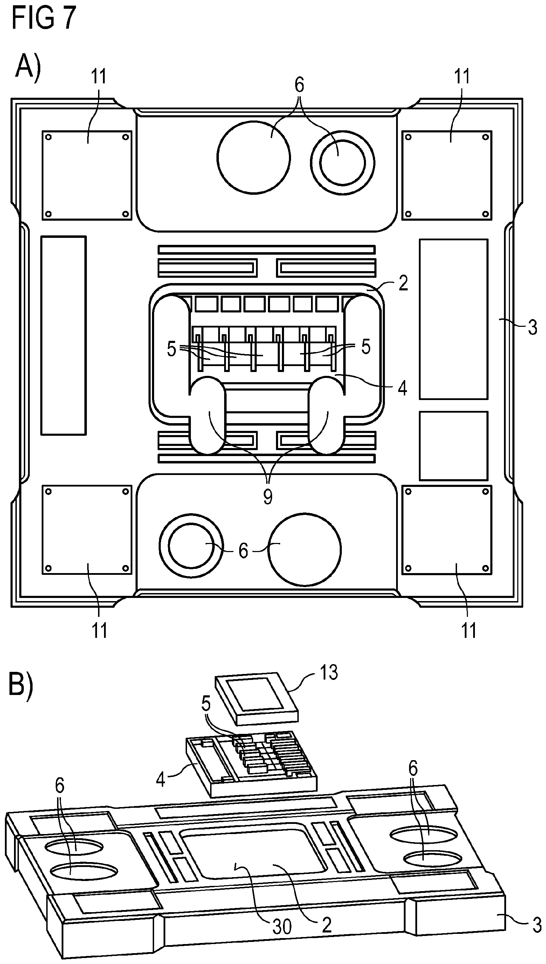

Eine Abwandlung eines Leuchtmoduls ist in der Draufsicht in Figur 7A sowie in der perspektivischen Darstellung in Figur 7B zu sehen. Der Träger 4 mit dem Halbleiterchip 5 ist in der Öffnung 2 der Leiterplatte 3 auf die Leiterplattenoberseite 30 mittels einer Verbindungsmittelschicht 12 aufgeklebt. Die Öffnung 2 durchdringt die Leiterplatte 3, die einen vergleichsweise dicken metallischen Kern umfasst, nicht vollständig, so dass eine Wanne gebildet ist, in der der Träger 4 angebracht ist. Eine mechanische Verbindung zwischen dem Träger 4 und der Leiterplatte 3 erfolgt im Wesentlichen nur über die Verbindungsmittelschicht 12. Da die Verbindungsmittelschicht 12 zwischen der Leiterplatte 3 und dem Träger 4 liegt, ist ein thermischer Widerstand im Vergleich zu den Ausführungsbeispielen gemäß den Figuren 1 bis 6 erhöht.

Die hier beschriebene Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Patentanmeldung beansprucht die Priorität der deutschen Patentanmeldung 10 2010 033 092.2, deren Offenbarungsgehalt hiermit durch Rückbezug aufgenommen wird.

## Patentansprüche

1. Optoelektronisches Leuchtmodul (1) mit
- einem Kühlkörper (8) mit einer Kühlkörperoberseite (80),
- einer Leiterplatte (3),
- einem Träger (4) mit einer Trägeroberseite (40) und einer dieser gegenüberliegenden Trägerunterseite (45),
- mindestens einem optoelektronischen Halbleiterchip (5), der an der Trägeroberseite (40) angebracht und mit dem Träger elektrisch verbunden ist,
- mindestens einer Haltevorrichtung (7), die unmittelbar an der Trägeroberseite (30) aufliegt und die die Trägerunterseite (45) an die Kühlkörperoberseite (80) andrückt,
wobei der Träger (4) elektrisch mit der Leiterplatte (3) verbunden und die Haltevorrichtung (7) von dem Halbleiterchip (5) elektrisch isoliert ist, wobei
- der Träger (4) in Richtung parallel zur Trägeroberseite (40) von der Leiterplatte (3) beabstandet ist, sodass in Draufsicht auf die Kühlkörperoberseite (80) gesehen eine Lücke zwischen dem Träger (4) und der Leiterplatte (3) gebildet ist,
- die Lücke zwischen dem Träger (4) und der Leiterplatte (3) von einer elektrischen Brücke (9) überspannt ist,
- die Brücke (9) elektrische Leiterbahnen (10) an der Trägeroberseite (40) mit korrespondierenden elektrischen Leiterbahnen (10) an einer Leiterplattenoberseite (30) der Leiterplatte (3) verbindet,
- die Haltevorrichtung (7) als Bügel, Band oder als Feder gestaltet ist, und
- die Haltevorrichtung (7) aus einem Material mit einer Wärmeleitfähigkeit von mindestens 80 W/(K•m) geformt ist.

2. Optoelektronisches Leuchtmodul (1) nach dem vorhergehenden Anspruch,
bei dem die Haltevorrichtung (7) durch erste Teile (7a) und durch zweite Teile (7b) gebildet ist,
wobei die ersten Teile (7a) Bügel sind, die durch Öffnungen (2) hindurch von einer Rückseite des Kühlkörpers (8) zu der Trägeroberseite (40) reichen, wobei die zweiten Teile (7b) durch Schrauben gebildet sind, und
wobei durch ein Anziehen der Schrauben die Bügel an die Trägeroberseite (40) angedrückt sind, wodurch eine Befestigung des Trägers (4) erfolgt ist.

3. Optoelektronisches Leuchtmodul (1) nach einem der vorhergehenden Ansprüche,
bei dem die Haltevorrichtung (7) den Träger (4) mit einer mechanische Kraft zwischen einschließlich 5 N und 100 N und/oder mit einem mittleren Druck zwischen einschließlich 0,2 MPa und 20 MPa an die Kühlkörperoberseite (80) andrückt.

4. Optoelektronisches Leuchtmodul (1) nach einem der vorhergehenden Ansprüche,
bei dem die Trägerunterseite (45) und die Kühlkörperoberseite (80) jeweils eine mittlere Rauheit von höchstens 10 µm aufweisen.

5. Optoelektronisches Leuchtmodul (1) nach einem der vorhergehenden Ansprüche,
bei dem die Trägerunterseite (45) mindestens stellenweise in unmittelbarem Kontakt zu der Kühlkörperoberseite (80) steht.

6. Optoelektronisches Leuchtmodul (1) nach einem der Ansprüche 1 bis 4,
bei dem sich zwischen der Trägerunterseite (45) und der Kühlkörperoberseite (80) mindestens stellenweise eine Zwischenschicht (14) zur Verbesserung der thermischen Ankopplung des Trägers (4) an den Kühlkörper (8) befindet,
wobei eine mittlere Dicke der Zwischenschicht (14) höchstens 1 µm beträgt.

7. Optoelektronisches Leuchtmodul (1) nach Anspruch 5, wobei
- die Trägerunterseite (45) und diejenigen Bereiche der Kühlkörperoberseite (80), auf denen der Träger (4) aufliegt, planar und eben geformt sind, sodass der Träger (4) und der Kühlkörper (8) flach aneinander anliegen,
- die Trägerunterseite (45) ganzflächig die Kühlkörperoberseite (80) berührt,
wobei die Leiterplatte (3) eine Ausnehmung aufweist, die die Leiterplatte (3) vollständig durchdringt,
- die Leiterplatte (3) in lateraler Richtung den Träger (4) ringsum umgibt,
- sich in der Ausnehmung der Träger (4) mit dem mindestens einen Halbleiterchip (5) befindet,
- der Träger (4) in eine Richtung weg von dem Kühlkörper (8) die Leiterplatte (3) wenigstens stellenweise überragt,
- die Haltevorrichtung (7), die den Träger (4) an den Kühlkörper (8) andrückt, nicht in Kontakt mit der Leiterplatte (3) steht, sodass sich die Leiterplatte (3) und die Haltevorrichtung (7) nicht berühren.

8. Optoelektronisches Leuchtmodul (1) nach einem der vorhergehenden Ansprüche,
bei dem der Kühlkörper (8) eine Wanne (12) aufweist, in der der Trägers (4) angebracht ist,
wobei der Träger (4) die Wanne (12) überragt.

9. Optoelektronisches Leuchtmodul (1) nach einem der vorhergehenden Ansprüche,
bei dem die Haltevorrichtung (7) stellenweise in unmittelbarem thermischen Kontakt mit dem Kühlkörper (8) steht.

10. Optoelektronisches Leuchtmodul (1) nach einem der vorhergehenden Ansprüche,
bei dem ein mittlerer thermischer Ausdehnungskoeffizient der Leiterplatte (3) und/oder des Kühlkörpers sich von einem mittleren thermischen Ausdehnungskoeffizienten des Trägers (4) höchstens um einen Faktor 4 unterscheidet.

11. Optoelektronisches Leuchtmodul (1) nach einem der vorhergehenden Ansprüche,
bei dem an mindestens einer Seitenfläche (48) des Trägers (4) ein Anschlag (13) angebracht ist, der in Kontakt mit der Kühlkörperoberseite (80) steht, wobei der Anschlag (13) dazu eingerichtet ist, ein laterales Verschieben des Trägers (4) relativ zu der Kühlkörperoberseite (80) zu unterbinden oder zu reduzieren.

12. Optoelektronisches Leuchtmodul (1) nach einem der vorhergehenden Ansprüche,
bei dem der Träger (4) eine Keramik oder ein Halbleitermaterial aufweist oder hieraus besteht, wobei eine Dicke des Trägers (4) zwischen einschließlich 200 µm und 1 mm liegt.

13. Optoelektronisches Leuchtmodul (1) nach einem der vorhergehenden Ansprüche,
bei dem die Haltevorrichtung (7) dauerhaft und nicht reversibel lösbar an dem Kühlkörper (8) befestigt ist.

14. Kfz-Scheinwerfer mit mindestens einem optoelektronischen Leuchtmodul (1) nach einem der vorhergehenden Ansprüche.

## Claims

1. An optoelectronic lighting module (1) comprising
- a heat sink (8) having a heat sink top side (80),
- a circuit board (3),
- a carrier (4) having a carrier top side (40) and a carrier underside (45) lying opposite said carrier top side,
- at least one optoelectronic semiconductor chip (5) which is attached to the carrier top side (40) and is electrically connected to the carrier,
- at least one holding device (7) which is arranged directly on the carrier top side (30) and which presses the carrier underside (45) against the heat sink top side (80),
wherein the carrier (4) is electrically connected to the circuit board (3) and the holding device (7) is electrically insulated from the semiconductor chip (5),
wherein
- the carrier (4) is distant from the circuit board (3) in the direction parallel to the carrier top side (40) so that, in a plan view of the heat sink top side (80), a gap is formed between the carrier (4) and the circuit board (3),
- the gap between the carrier (4) and the circuit board (3) is spanned by an electrical bridge (9),
- the bridge (9) has electrical conductor tracks (10) on the carrier top side (40) to corresponding electrical conductor tracks (10) on a circuit board upper side (30) of the circuit board (3),
- the holding device (7) is designed as a bracket, band or as a spring, and
- the holding device (7) is formed from a material having a thermal conductivity of at least 80 W/(K•m).

2. The optoelectronic lighting module (1) according to the preceding claim,
in which the holding device (7) is formed by first parts (7a) and by second parts (7b),
wherein the first parts (7a) are brackets which are formed by openings (2) from a rear side of the heat sink (8) to the carrier top side (40),
wherein the second parts (7b) are formed by screws, and wherein the brackets are pressed against the carrier top side (40) by tightening the screws, as a result of which the carrier (4) is fastened.

3. The optoelectronic lighting module (1) according to one of the preceding claims,
in which the holding device (7) supports the carrier (4) with a mechanical force of between 5 N and 100 n inclusive and/or with a mean pressure between 0.2 MPa and 20 MPa inclusive against the heat sink top side (80).

4. The optoelectronic lighting module (1) according to one of the preceding claims,
in which the carrier underside (45) and the heat sink top side (80) each have an average roughness of at most 10 µm.

5. The optoelectronic lighting module (1) according to one of the preceding claims,
in which the carrier underside (45) is in direct contact with the heat sink top side (80) at least in places.

6. The optoelectronic lighting module (1) according to one of claims 1 to 4,
in which between the carrier underside (45) and the heat sink top side (80) at least in places an intermediate layer (14) for improving the thermal coupling of the carrier (4) to the heat sink (8) is located,
wherein an average thickness of the intermediate layer (14) is at most 1 µm.

7. The optoelectronic lighting module (1) according to claim 5,
wherein
- the carrier underside (45) and those regions of the heat sink top side (80) on which the carrier (4) rests are planar and flat, so that the carrier (4) and the heat sink (8) rest flat against one another,
- the carrier underside (45) touches the heat sink top side (80) over the whole area,
wherein the circuit board (3) has a recess which completely penetrates the circuit board (3),
- the circuit board (3) surrounds the carrier (4) all around in the lateral direction,
- the carriers (4) with the at least one semiconductor chip (5) is located in the recess,
- the carrier (4) projects beyond the circuit board (3) at least in places in a direction away from the heat sink (8),
- the holding device (7), which presses the carrier (4) against the heat sink (8), is not in contact with the circuit board (3) so that the circuit board (3) and the holding device (7) do not touch each other.

8. The optoelectronic lighting module (1) according to one of the preceding claims,
in which the heat sink (8) has a trough (12) in which the carrier (4) is mounted,
wherein the carrier (4) projects beyond the trough (12).

9. The optoelectronic lighting module (1) according to one of the preceding claims,
in which the holding device (7) is in direct thermal contact with the heat sink (8) in places.

10. The optoelectronic lighting module (1) according to one of the preceding claims,
in which a mean coefficient of thermal expansion of the circuit board (3) and/or of the heat sink differs from a mean coefficient of thermal expansion of the carrier (4) by at most a factor of 4.

11. The optoelectronic lighting module (1) according to one of the preceding claims,
in which a stop (13) is applied on at least one side surface of the carrier (4), the stop (13) is in contact with the heat sink top side (80),
wherein the stop (13) is designed to prevent a lateral displacement of the carrier (4) relative to the heat sink top side (80).

12. The optoelectronic lighting module (1) according to one of the preceding claims,
in which the carrier (4) comprises or consists of a ceramic or a semiconductor material,
wherein a thickness of the carrier (4) is between 200 µm and 1 mm inclusive.

13. The optoelectronic lighting module (1) according to one of the preceding claims,
in which the holding device (7) is permanently and non-reversibly detachably fastened to the heat sink (8).

14. A motor vehicle headlight comprising at least one optoelectronic lighting module (1) according to one of the preceding claims.

## Revendications

1. Module lumineux optoélectronique (1) doté
- d'un refroidisseur (8) muni d'une face supérieure de refroidisseur (80),
- d'un circuit imprimé (3),
- d'un support (4) muni d'une face supérieure de support (40) et d'une face inférieure de support (45) opposée à la première,
- d'au moins une puce semi-conductrice optoélectronique (5) qui est fixée à la face supérieure du support (40) et connectée électriquement au support,
- d'au moins un dispositif de maintien (7) qui repose directement sur la face supérieure du support (30) et qui presse la face inférieure du support (45) sur la face supérieure du refroidisseur (80),
le support (4) étant connecté électriquement au circuit imprimé (3) et le dispositif de maintien (7) étant isolé électriquement de la puce semi-conductrice (5),
- le support (4) étant, dans le sens parallèle à la face supérieure du support (40), espacé du circuit imprimé (3) de telle sorte que, lorsqu'on regarde la face supérieure du refroidisseur (80) vue d'en haut, un espace est formé entre le support (4) et le circuit imprimé (3),
- un pont électrique (9) enjambant l'espace entre le support (4) et le circuit imprimé (3),
- ledit pont (9) reliant des pistes conductrices (10) sur la face supérieure du support (40) à des pistes conductrices (10) électriques correspondantes sur une face supérieure de circuit imprimé (30) du circuit imprimé (3),
- le dispositif de maintien (7) étant conçu sous forme d'étrier, de bande ou de ressort, et
- le dispositif de maintien (7) étant formé dans un matériau d'une conductivité de chaleur d'au moins 80 W/(K•m).

2. Module lumineux optoélectronique (1) selon la revendication précédente, dans lequel le dispositif de maintien (7) est constitué de premières parties (7a) et de secondes parties (7b),
les premières parties (7a) étant des étriers qui passent, au travers d'ouvertures (2), d'une face arrière du refroidisseur (8) à la face supérieure du support (40),
les deuxièmes parties (7b) étant constituées de vis et les étriers étant pressés sur la face supérieure du support (40) par un serrage des vis, réalisant ainsi une fixation du support (4).

3. Module lumineux optoélectronique (1) selon l'une quelconque des revendications précédentes, dans lequel le dispositif de maintien (7) presse le support (4) à la face supérieure du refroidisseur (80) à une force mécanique comprise entre 5 N inclus et 100 N et/ou à une pression moyenne comprise entre 0,2 MPa inclus et 20 MPa.

4. Module lumineux optoélectronique (1) selon l'une quelconque des revendications précédentes, dans lequel la face inférieure du support (45) et la face supérieure du refroidisseur (80) présentent chacune une rugosité moyenne de 10 µm maximum.

5. Module lumineux optoélectronique (1) selon l'une quelconque des revendications précédentes, dans lequel la face inférieure du support (45) est au moins partiellement en contact direct avec la face supérieure du refroidisseur (80).

6. Module lumineux optoélectronique (1) selon l'une quelconque des revendications 1 à 4, dans lequel se trouve, entre la face inférieure du support (45) et la face supérieure du refroidisseur (80), au moins partiellement une couche intermédiaire (14) destinée à améliorer le couplage thermique du support (4) au refroidisseur (8), une épaisseur moyenne de la couche intermédiaire (14) étant d'1 µm maximum.

7. Module lumineux optoélectronique (1) selon la revendication 5,
- la face inférieure du support (45) et les zones de la face supérieure du refroidisseur (80) sur lesquelles repose le support (4) étant conçues planaires et plates de telle sorte que le support (4) et le refroidisseur (8) sont accolés à plat l'un contre l'autre,
- la face inférieure du support (45) touchant sur toute la surface la face supérieure du refroidisseur (80), le circuit imprimé (3) présentant une entaille traversant entièrement le circuit imprimé (3),
- le circuit imprimé (3) entourant dans le sens latéral le support (4) tout autour,
- le support (4) se trouvant avec l'au moins une puce semi-conductrice (5) dans l'entaille,
- le support (4) saillant au moins en partie du circuit imprimé (3) dans un sens opposé au refroidisseur (8),
- le dispositif de maintien (7), lequel presse le support (4) au refroidisseur (8), n'étant pas en contact avec le circuit imprimé (3) de telle sorte que le circuit imprimé (3) et le dispositif de maintien (7) ne se touchent pas.

8. Module lumineux optoélectronique (1) selon l'une quelconque des revendications précédentes, dans lequel le refroidisseur (8) présente une cuvette (12) dans laquelle est fixé le support (4),
le support (4) dépassant la cuvette (12).

9. Module lumineux optoélectronique (1) selon l'une quelconque des revendications précédentes, dans lequel le dispositif de maintien (7) est partiellement en contact thermique direct avec le refroidisseur (8).

10. Module lumineux optoélectronique (1) selon l'une quelconque des revendications précédentes, dans lequel un coefficient d'allongement thermique moyen du circuit imprimé (3) et/ou du refroidisseur diffère d'un facteur 4 maximum d'un coefficient d'allongement thermique moyen du support (4).

11. Module lumineux optoélectronique (1) selon l'une quelconque des revendications précédentes, dans lequel est apportée sur au moins une face latérale (48) du support (4) une butée (13) qui est en contact avec la face supérieure du refroidisseur (80), ladite butée (13) étant destinée à empêcher ou à réduire un déplacement latéral du support (4) par rapport à la face supérieure du refroidisseur (80).

12. Module lumineux optoélectronique (1) selon l'une quelconque des revendications précédentes, dans lequel le support (4) présente ou est constitué d'une céramique ou d'un matériau semi-conducteur,
une épaisseur du support (4) étant d'entre 200 µm inclus et 1 mm.

13. Module lumineux optoélectronique (1) selon l'une quelconque des revendications précédentes, dans lequel le dispositif de maintien (7) est fixé durablement et détachable de manière irréversible au refroidisseur (8) .

14. Projecteur de véhicule automobile doté d'au moins un module lumineux optoélectronique (1) selon l'une quelconque des revendications précédentes.
